## Europäisches Patentamt

## European Patent Office

## Office européen des brevets

(19)

(11) Veröffentlichungsnummer: **0 167 078**
**B1**

(12) **EUROPÄISCHE PATENTSCHRIFT**

(45) Veröffentlichungstag der Patentschrift:
**14.09.88**

(21) Anmeldenummer: **85107780.0**

(22) Anmeldetag: **24.06.85**

(51) Int. Cl.⁴: **H 01 L 31/10, H 01 L 31/02**

(54) **Anordnung mit einem lichtzündbaren Thyristor.**

(30) Priorität: **05.07.84 DE 3424805**

(43) Veröffentlichungstag der Anmeldung:
**08.01.86 Patentblatt 86/2**

(45) Bekanntmachung des Hinweises auf die Patenterteilung:
**14.09.88 Patentblatt 88/37**

(84) Benannte Vertragsstaaten:
**AT CH DE FR GB IT LI SE**

(56) Entgegenhaltungen:
**EP - A - 0 053 020**
**GB - A - 1 579 619**
**US - A - 4 257 058**
**US - A - 4 374 393**

(73) Patentinhaber: **Siemens Aktiengesellschaft Berlin und München, Wittelsbacherplatz 2, D-8000 München 2 (DE)**

(72) Erfinder: **Führer, Wolfgang, Dipl.-Ing., Am Europakanal 4, D-8520 Erlangen (DE)**
Erfinder: **Müller, Thomas, Dipl.-Ing., Am Europakanal 45, D-8520 Erlangen (DE)**

## Beschreibung

Die Erfindung betrifft eine Anordnung mit einem lichtzündbaren Thyristor, der zwischen zwei Kühlkörper eingespannt ist, wobei der scheibenförmige Halbleiterkörper des Thyristors in einem Gehäuse angeordnet ist, das mit einer anoden- und einer kathodenseitigen Druckfläche versehen ist, an die die Kühlkörper angepresst sind und in dessen Wandung eine optische Durchführung für einen geführten Lichtstrom angeordnet ist.

Solche Anordnungen, bzw. lichtzündbare Thyristoren für solche Anordnungen sind aus der US-A 4 374 393 oder dem Artikel von S. Kobayashi e.a. «Performance of High Voltage Light-Triggered Thyristor Valve» 83 WM 171-6 IEE Power Engineering Society, New York, 1982 oder dem Artikel von D. Silber e.a. «Lichtzündung von Leistungsthyristoren» Forschungsbericht BMFT-FB-T-81071, Frankfurt 1981, bekannt. Solche lichtgezündeten Thyristoren werden durch Lichtimpulse einer gewissen Mindestenergie bei anliegender Spannung vom gesperrten in den leitenden Zustand gebracht. Die lichtempfindliche Fläche des Thyristors befindet sich kathodenseitig im Zentrumsbereich der Halbleiterscheibe. Das Licht muss daher durch die Gehäusewandung des Thyristors hindurchgeführt und zu diesem lichtempfindlichen Bereich geleitet werden. Bei den bekannten lichtzündbaren Thyristoren wird im Gehäuse das Licht mit Lichtwellenleitern abgelenkt und zu der lichtempfindlichen Fläche geführt. Die Führung des Lichtimpulses mit Lichtwellenleitern erfordert viel Raum. Die optische Durchlassöffnung ist im Isolierteil des Gehäuses angeordnet, womit die Spannungsaufteilung längs dieses Isolierteils gestört wird. Bei kleineren Thyristoren ist es auch bekannt, die optische Durchführung in Flächen vorzusehen, die weder für die Montage noch für die Kühlung benötigt werden.

Es besteht die Aufgabe, eine Anordnung der eingangs genannten Art so auszubilden, dass eine Umlenkung des Lichtimpulses im Gehäuse nicht mehr erforderlich ist.

Erfindungsgemäss wird diese Aufgabe dadurch gelöst, dass die Durchführung in der kathodenseitigen Druckfläche unmittelbar im Bereich der lichtempfindlichen Fläche des Halbleiterkörpers liegt und dass das Licht in einer Bohrung des kathodenseitigen Kühlkörpers zu dieser Durchführung geführt ist.

Bei der erfindungsgemässen Anordnung wird der Lichtimpuls in der Kühlfläche bzw. bei Kühlkörpern, die auch zur Stromführung dienen, in der elektrischen Kontaktfläche in das Gehäuse eingeführt und trifft unmittelbar auf die lichtempfindliche Fläche des Halbleiterkörpers, ohne im Gehäuse umgelenkt werden zu müssen. Damit erfolgt die Lichtankopplung in einer elektrischen Potentialfläche und eine Störung der Spannungsaufteilung längs des Isolierteils wird vermieden. Die Kühlkörper bieten genügend Raum für verlustarme Umlenkungen des Lichtstromes, wobei es vorteilhaft ist, die Bohrung im Kühlkörper etwa um 90° umzulenken, damit sie an einer Seitenfläche des Kühlkörpers mündet. Dabei kann die Umlenkung mit grossem Radius erfolgen, was zu kleinen Dämpfungen, insbesondere beim Einsatz von Lichtwellenleitern führt.

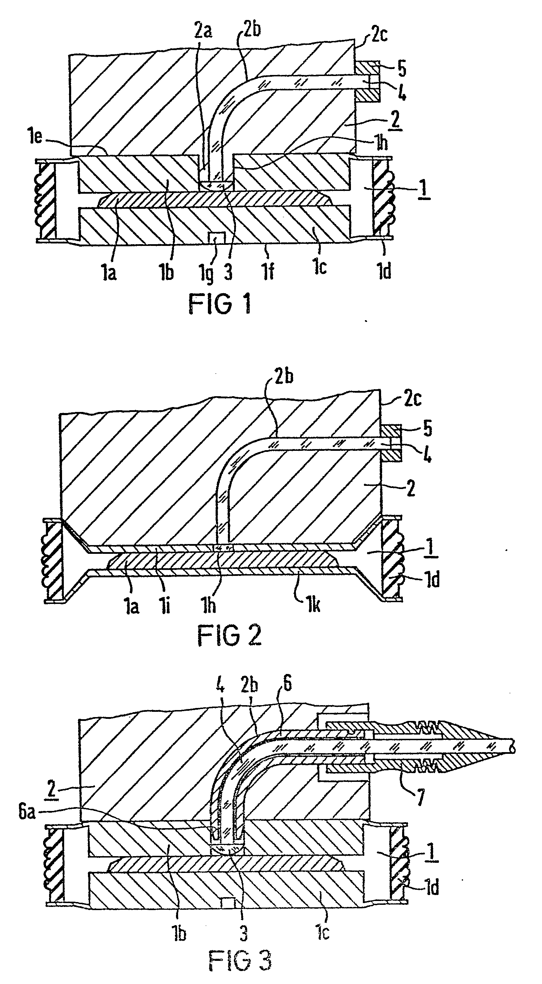

Im folgenden wird die erfindungsgemässe Anordnung beispielhaft anhand der Figuren 1 bis 4 näher erläutert. In den Figuren sind gleiche Bauteile mit den gleichen Bezugszeichen versehen.

Der Schnitt nach Figur 1 zeigt einen Scheibenthyristor 1 mit einem Flachboden-Scheibengehäuse. Das Halbleiterplättchen 1a ist zwischen zwei Druckscheiben 1b und 1c aus elektrisch wärmeleitendem Material angeordnet, die an einem ringförmigen Isolierkörper 1d befestigt sind. Jede Druckscheibe 1b bzw. 1c besitzt eine Anpressfläche 1e bzw. 1f, an die in herkömmlicher Weise je ein Kühlkörper 2 angepresst wird. In der Figur ist nur der kathodenseitige Kühlkörper gezeigt, um die Übersichtlichkeit zu wahren. Üblicherweise sind die Druckscheiben 1b und 1c mit Zentrierbohrungen 1g versehen, um die Montage zu erleichtern. Beim Ausführungsbeispiel nach Figur 1 ist die Zentrierbohrung der kathodenseitigen Druckscheibe 1b zu einer Öffnung 1h erweitert, die direkt über dem lichtempfindlichen Bereich im Zentrum des Halbleiterplättchens 1a liegt und mit einer Optik 3 verschlossen ist. In die Öffnung 1h greift ein Vorsprung 2a des Kühlkörpers 2 ein, in dem eine Bohrung 2b im Kühlkörper 2 vor der Optik 3 mündet. Beim Ausführungsbeispiel ist in der Bohrung 2b ein Lichtwellenleiter 4 geführt, der in einer konventionellen Lichtwellenleiterkupplung 5 an der Seitenfläche 2c des Kühlkörpers mündet. Eine solche Lichtwellenleiterkupplung ist beispielhaft in dem US-A 4 374 393 beschrieben. Die Bohrung 2b ist im Kühlkörper 2 mit einem grossen Radius etwa um 90° umgelenkt, damit der Lichtwellenleiter 4 über die Seitenfläche 2c des Kühlkörpers 2 eingeführt werden kann.

Bei der in Figur 1 gezeigten Anordnung wird der Lichtimpuls ohne Ablenkung im Gehäuse direkt auf die lichtempfindliche Fläche abgebildet. Der Thyristor 1 kann daher raumsparend aufgebaut werden. Die Lichtankopplung erfolgt dabei in einer elektrischen Potentialfläche, so dass die Spannungsaufteilung längs des Isolierteils 1d ungestört bleibt. Da die Bohrung 2b im Kühlkörper 2 mit einem grossen Radius umgelenkt werden kann, erhält man für den zugeführten Lichtimpuls insbesondere bei der Verwendung von Lichtwellenleitern 4 nur eine kleine Dämpfung. Ausserdem werden, wie die Figur 1 verdeutlicht, mit dem Kühlkörper 2 auch die in diesem integrierten Steuerverbindungen angebracht, ohne dass hierfür zusätzliche Montageschritte nötig wären. Montage und Wartung der gezeigten Anordnung werden damit erleichtert. Zu betonen ist noch, dass der Kühlkörper 2 nicht nur genügend Raum für verlustarme Umlenkungen des Lichtstroms bietet, sondern dass der im Kühlkörper 2 zur Verfügung stehende Raum auch für Optiken und Lichtverstärkungseinrichtungen, beispielsweise optisch gepumpte Laser verwendet werden kann.

Figur 2 zeigt eine andere Ausführungsform im Schnitt. Das Gehäuse des Thyristors 1 besitzt dabei anstelle der Druckscheiben eingezogene Kontaktflächen 1i und 1k, wobei der Kühlkörper so geformt ist, dass er formschlüssig in die eingezogenen Kontaktflächen eingreift. In die kathodenseitige Kontaktfläche 1i ist im lichtempfindlichen Bereich des Halbleiterplättchens 1a wiederum eine optische Durchlassöffnung 1h angeordnet, die als Sammeloptik ausgebildet sein kann. Wie im Ausführungsbeispiel nach Figur 1 mündet über der Durchlassöffnung 1h die Bohrung 2b im Kühlkörper 2. Die im Zusammenhang mit Figur 1 geschilderten Vorteile sind auch bei dieser Ausführungsform gewährleistet.

Figur 3 zeigt eine Abänderung des Ausführungsbeispiels nach Figur 1. Bei diesem Ausführungsbeispiel ist in die Bohrung 2b im Kühlkörper 2 ein Führungsrohr 6 eingebracht, dessen Ende 6a in die Öffnung 1h eingreift. Bei diesem Ausführungsbeispiel kann der Lichtleiter 4 nachträglich in das Führungsrohr 6 direkt eingesteckt werden und mit einer federnden Stecktülle 7, die am Führungsrohr 6 einrastet und fest mit dem Lichtleiter 4 verbunden ist, gehalten werden. Damit ist es möglich, ohne zusätzliche Kopplungsstelle einen durchgehenden Lichtwellenleiter von der Lichtquelle zum Thyristor zu führen, wobei die Kühleinrichtung nur als Umlenkung und Befestigung dient.

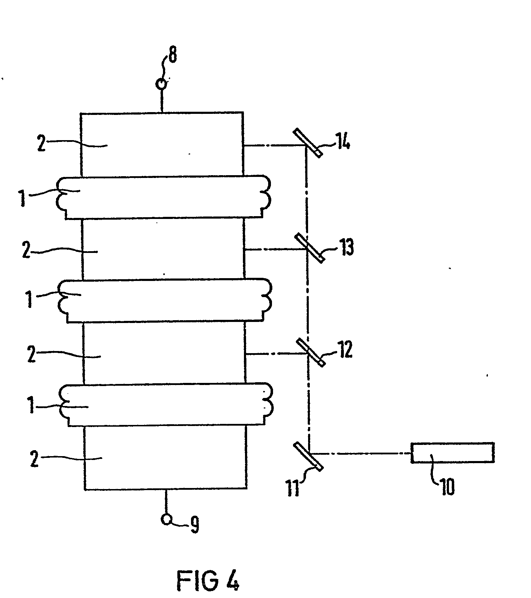

Figur 4 zeigt schliesslich eine Thyristorsäule, mit lichtzündbaren Thyristoren 1, die zwischen Kühlkörpern 2 eingespannt sind, die auch zur elektrischen Stromführung dienen, wozu die beiden äusseren Kühlkörper 2 mit dem Kathodenanschluss 8 und dem Anodenanschluss 9 verbunden sind. Mit diesem Ausführungsbeispiel wird eine optische Übertragungseinrichtung zu den Bohrungen 2b in den Kühlkörpern 2 demonstriert. Der benötigte Lichtimpuls wird in einem leistungsstarken Laser, beispielsweise einen $CO_2$-Laser 10 erzeugt. Über Spiegel 11, 12, 13 und 14 wird der Lichtstrahl in die Öffnungen der Bohrungen 2b in jeden Kühlkörper 2 abgebildet. Hierzu benötigt man Spiegel 11 und 14, die eine 100%ige Reflexion besitzen und teildurchlässige Spiegel 12 und 13, wobei der Spiegel 12 eine Reflexion von 33% und der Spiegel 13 eine Reflexion von 50% besitzen muss, um jeden Thyristor 1 mit einem ausreichend grossen Lichtimpuls zu zünden.

Zusammenfassend ist festzustellen, dass mit der erfindungsgemässen Anordnung Lichtumlenkungen im Gehäuse des Thyristors vermieden sind und auch die Lichtzuführungen dämpfungsarm ausgeführt werden können. Zu betonen ist noch, dass mit der erfindungsgemässen Ausgestaltung auch die Verwendung von lichtzündbaren Thyristoren mit mehreren lichtempfindlichen Flächen möglich ist, wie sie bei sehr grossen Halbleiterflächen auftreten können. Hierfür kann dann im kathodenseitigen Kühlkörper eine Aufteilung des Lichtimpulses auf mehrere Durchlassöffnungen im Thyristorgehäuse erfolgen oder es kann für jede Durchlassöffnung im Thyristorgehäuse eine gesonderte Bohrung angebracht werden. Die geschilderten Vorteile werden hiervon nicht beeinträchtigt. Zu erwähnen ist noch, dass sich die Erfindung auch bei einseitig gekühlten Thyristoren einsetzen lässt, bei denen der zweite Kühlkörper durch Teile einer Einspannvorrichtung ersetzt ist.

## Patentansprüche

1. Anordnung mit einem lichtzündbaren Thyristor, der zwischen zwei Kühlkörper eingespannt ist, wobei der scheibenförmige Halbleiterkörper des Thyristors in einem Gehäuse angeordnet ist, das mit einer anoden- und einer kathodenseitigen Druckfläche versehen ist, an die die Kühlkörper angepresst sind und in dessen Wandung eine optische Durchführung für einen geführten Lichtstrom angeordnet ist, dadurch gekennzeichnet, dass die Durchführung (1h) in der kathodenseitigen Druckfläche (1e) unmittelbar im Bereich der lichtempfindlichen Fläche des Halbleiterkörpers (1a) liegt und dass das Licht in einer Bohrung (2b) des kathodenseitigen Kühlkörpers (2) zu dieser Durchführung (1h) geführt ist.

2. Anordnung nach Anspruch 1, dadurch gekennzeichnet, dass die Bohrung (2b) im Kühlkörper (2) etwa um 90° umgelenkt ist und an einer Seitenfläche (1c) des Kühlkörpers (2) mündet.

## Claims

1. Arrangement having a photo-ignitable thyristor which is fixed between two cooling bodies, wherein the disc-shaped semi-conductor body of the thyristor is arranged in a housing which is provided with an anode-side and a cathode-side pressure surface against which the cooling bodies are pressed and in whose wall and optical aperture for a guided light flux is arranged, characterised in that the aperture (1h) in the cathode-side pressure surface (1e) lies directly in the region of the light-sensitive surface of the semi-conductor body (1a) and in that the light is guided in a bore (2b) of the cathode-side cooling body (2) to this aperture (1h).

2. Arrangement according to claim 1, characterised in that the bore (2b) in the cooling body (2) is deflected approximately by 90° and opens on a side surface (1c) of the cooling body.

## Revendications

1. Dispositif comportant un thyristor pouvant être amorcé par la lumière et qui est enserré entre deux radiateurs, le corps semiconducteur en forme de disque du thyristor étant disposé dans un boîtier qui comporte une surface de pression située du côté anode et une surface de pression située du côté cathode et contre lesquelles les radiateurs sont repoussés, et dans la paroi duquel se trouve disposée une traversée obtique pour un flux limineux guidé, caractérisé par le fait que la traversée (1h) est située dans la surface de pression (1e) située du côté cathode, directement au voisinage de la surface photosensible du corps semiconducteur (1a) et que la lumière est guidée dans un perçage (2b) du radiateur (2) situé du côté de la cathode, jusqu'à cette traversée (1h).

2. Dispositif suivant la revendication 1, caractérisé par le fait que le perçage (2b) ménagé dans le radiateur (2) est coudé à environ 90° et débouche dans une surface latérale (1c) du radiateur (2).

FIG 1

FIG 2

FIG 3

**FIG 4**